# EUROPÄISCHE PATENTSCHRIFT

(11) **EP 1 373 983 B1**
(45) Veröffentlichungstag und Bekanntmachung des Hinweises auf die Patenterteilung: **07.06.2006**
(21) Anmeldenummer: 02745198.8
(22) Anmeldetag: 28.03.2002
(51) Int. Cl.: G03F 7/20, G03H 1/08

(54) **LITHOGRAPH MIT TRIGGERMASKE, VERFAHREN ZUM HERSTELLEN DIGITALER HOLOGRAMME IN EINEM SPEICHERMEDIUM UND MIKROSKOP**
LITHOGRAPH WITH A TRIGGER MASK, METHOD OF PRODUCTION OF DIGITAL HOLOGRAMS IN A STORAGE MEDIUM AND MICROSCOPE
LITHOGRAPHE POURVU D'UN MASQUE DE DECLENCHEMENT, PROCEDE DE PRODUCTION D'HOLOGRAMMES NUMERIQUES DANS UN MOYEN MEMOIRE ET MICROSCOPE

(30) Priorität: 30.03.2001 DE 10116060
(43) Veröffentlichungstag der Anmeldung: 02.01.2004
(73) Patentinhaber: tesa scribos GmbH, 69126 Heidelberg (DE)
(72) Erfinder: NOEHTE, Steffen, 69469 Weinheim (DE); DIETRICH, Christoph, 69126 Heidelberg (DE); THOMANN, Robert, 69121 Heidelberg (DE); GERSPACH, Matthias, 69121 Heidelberg (DE); STADLER, Stefan, 22359 Hamburg (DE); LEIBER, Jörn, 22529 Hamburg (DE)
(74) Vertreter: Rox, Thomas
(86) Internationale Anmeldenummer: PCT/EP2002/003518
(87) Internationale Veröffentlichungsnummer: WO 2002/084405

(56) Entgegenhaltungen:
- EP-A- 0 947 884
- EP-A- 0 950 924
- EP-A- 0 965 888
- US-A- 3 925 785
- US-A- 4 688 932

## Beschreibung

Die vorliegende Erfindung betrifft einen Lithographen zum Herstellen digitaler Hologramme in einem Speichermedium. Insbesondere weist der Lithograph eine Lichtquelle zum Erzeugen eines Schreibstrahls, Antriebsmittel zum zweidimensionalen Bewegen des Schreibstrahls relativ zum Speichermedium und ein erstes Objektiv zum Fokussieren des Schreibstrahls auf das zu beschreibende Speichermedium auf. Darüber hinaus betrifft die Erfindung ein Verfahren zum Herstellen digitaler Hologramme in einem Speichermedium.

Digitale Hologramme sind zweidimensionale Hologramme, die aus einzelnen Punkten mit unterschiedlichen optischen Eigenschaften bestehen und aus denen bei Beleuchtung mit einer kohärenten elektromagnetischen Welle, insbesondere Lichtwelle durch Beugung in Transmission oder Reflexion Bilder und/oder Daten reproduziert werden. Die unterschiedlichen optischen Eigenschaften der einzelnen Punkte können Reflexionseigenschaften beispielsweise durch Oberflächentopographie, variierende optische Weglängen im Material des Speichermediums (Brechungsindizes) oder Farbwerte des Materials sein.

Die optischen Eigenschaften der einzelnen Punkte werden von einem Computer berechnet, es handelt sich somit um sogenannte computergenerierte Hologramme (CGH). Mit Hilfe des fokussierten Schreibstrahls werden während des Schreibens des Hologramms die einzelnen Punkte des Hologramms in das Material eingeschrieben, wobei der Fokus im Bereich der Oberfläche oder im Material des Speichermediums liegt. Eine Fokussierung bewirkt im Bereich des Fokus eine geringe Einwirkungsfläche auf das Material des Speichermediums, so daß eine Vielzahl von Punkten des Hologramms auf einer kleinen Fläche geschrieben werden kann. Die optische Eigenschaft des jeweils geschriebenen Punktes hängt dabei von der Intensität des Schreibstrahls ab. Dazu wird der Schreibstrahl in zwei Dimensionen mit variierender Intensität über die Oberfläche des Speichermediums gescannt. Die Modulation der Intensität des Schreibstrahls erfolgt dabei entweder über eine interne Modulation der Lichtquelle, beispielsweise eine Laserdiode, oder über eine externe Modulation eines Schreibstrahls außerhalb der Lichtquelle, beispielsweise mit Hilfe von optoelektronischen Elementen. Darüber hinaus kann die Lichtquelle als gepulster Laser ausgebildet sein, dessen Pulslängen steuerbar sind, so dass über die Pulslängen eine Steuerung der Intensität des Schreibstrahls erfolgen kann.

Durch das Abscannnen des intensitätsmodulierten Schreibstrahls entsteht somit eine Fläche mit einer unregelmäßigen Punkteverteilung, das digitale Hologramm. Dieses kann zum Kennzeichnen und Individualisieren beliebiger Gegenstände eingesetzt werden.

Scannende lithographische Systeme sind an sich weit verbreitet. Beispielsweise werden scannende optische Systeme in herkömmliche Laserdrucker eingebaut. Diese Systeme können jedoch zur Herstellung von Hologrammen nicht eingesetzt werden, da sich die Anforderungen für diesen Anwendungszweck gegenüber denen bei Laserdruckern deutlich unterscheiden. Die Auflösung liegt bei guten Drucksystemen (bspw. Linotype-Hell, Linotronic 530) bei etwa 2500 dpi, während bei der Herstellung von Hologrammen eine Auflösung von etwa 25.000 dpi erforderlich ist. Außerdem werden bei der digitalen Holographie nur vergleichsweise kleine Flächen beschrieben. Diese sind beispielsweise 1 bis 5 mm² groß, wobei auch andere Größen möglich sind. Die Genauigkeit des Schreibrasters muß bei einem Lithographen zur Herstellung digitaler Hologramme von beispielsweise 1000 x 1000 Punkten auf einer Fläche von 1 x 1 mm² etwa ± 0,1 µm in beide orthogonale Richtungen betragen. Darüber hinaus sollte die Schreibgeschwindigkeit etwa 1 Mpixel/s betragen, damit jeweils ein Hologramm in einer Zeit von ca. 1s geschrieben werden kann. Die vorgenannten Größen sind beispielhaft und stellen keine Beschränkung der Erfindung dar.

Digitale Hologramme können mittels konventioneller Scanmethoden hergestellt werden, bei denen mit stehender Optik der Winkel des einfallenden Strahles variiert wird. Auf diesem Prinzip arbeiten beispielsweise Scanspiegellithographen mit Galvo- und/oder Polygonscannern.

Bei allen bisher bekannten Scanmethoden besteht ein Nachteil darin, dass keine Steuerung der genauen Positionierung des Schreibstrahls möglich ist, die bei den zu erreichenden Schreibgeschwindigkeiten ein vorgegebenes Punktraster des digitalen Hologramms einzuhalten in der Lage ist.

Der vorliegenden Erfindung liegt daher das technische Problem zugrunde, mittels optischer Lithographie computergenerierte Hologramme möglichst schnell und mit geringem Aufwand bei gleichzeitiger genauer Steuerung der Positionierung des Schreibstrahls zu schreiben.

Das zuvor aufgezeigte technische Problem wird gemäß einer ersten Lehre der Erfindung durch ein Verfahren mit den Merkmalen des Anspruches 1 gelöst. Es handelt sich um ein Verfahren, bei dem ein Schreibstrahl auf das Speichermedium fokussiert und zweidimensional relativ zum Speichermedium bewegt wird, bei dem ein Abtaststrahl auf eine eine Mehrzahl von Pixeln aufweisende Triggermatrix fokussiert und zweidimensional relativ zur Triggermatrix bewegt wird, wobei die Bewegung des Abtaststrahls mit der Bewegung des Schreibstrahls gekoppelt wird, bei dem dann, wenn der Abtaststrahl ein Pixel der Triggermatrix trifft, ein Positionstriggersignal erzeugt wird, bei dem mit Hilfe des Positionstriggersignals der Schreibstrahl aktiviert wird und an der dem Pixel der Triggermatrix zugeordneten Position auf dem Speichermedium einen Punkt des digitalen Hologramms erzeugt wird, und bei dem das Hologramm durch punktweises Einbringen von Strahlungsenergie geschrieben wird, wobei die Intensität des Schreibstrahls in Abhängigkeit von der Position des Schreibstrahls auf dem Speichermedium gesteuert wird.

Erfindungsgemäß ist erkannt worden, dass ein exaktes Positionieren des Schreibstrahls dann erfolgen kann. wenn der Schreibstrahl genau dann getriggert wird, wenn er sich an der vorgegebenen Position befindet. Da eine direkte Beobachtung des Speichermediums zur Kontrolle der Positionierung des Schreibstrahls ausscheidet, wird erfindungsgemäß mit Hilfe eines Abtaststrahls, dessen Bewegung mit der Bewegung des Schreibstrahls gekoppelt ist, eine Triggermatrix abgetastet, mit deren Hilfe Positionstriggersignale zum Steuern der Intensität des Schreibstrahls erzeugt werden.

Mit anderen Worten wird außerhalb des eigentlich zu beschreibenden Bereiches des Speichermediums die zweidimensionale Bewegung erfaßt und für eine Positionssteuerung des Schreibstrahls ausgewertet. Das Positionssteuersignal stellt also eine zeitliche Steuerung dar, mit der der Schreibstrahl während seiner kontinuierlichen scannenden Bewegung intensitätsgesteuert werden kann.

In bevorzugter Weise wird der Abtaststrahl in einem vorgegebenen Bewegungsverhältnis zum Schreibstrahl bewegt. Somit kann der Abtaststrahl eine Triggermatrix abscannen, deren Fläche größer als der zu beschreibende Bereich des Speichermediums ist. Ist die Triggermatrix beispielsweise 10-fach größer als das zu erzeugende Hologramm, so ist die Bewegung des Abtaststrahls im Verhältnis 10:1 proportional zur Bewegung des Schreibstrahls vergrößert. Soll also beispielsweise ein Hologramm mit einer Fläche von 1x1 mm² beschrieben werden, so scannt der Abtaststrahl eine Triggermatrix mit einer Fläche von 10x10 mm² ab.

Daher können in vorteilhafter Weise optoelektronische Arraydetektoren als Triggermatrizen verwendet werden, deren Pixelauflösung im Bereich von 10 µm liegt, um ein Punktraster des Hologramms mit 1 µm Auflösung zu beschreiben.

Dazu wird weiter vorzugsweise der Abtaststrahl auf eine Größe fokussiert, die maximal der Pixelabmessung der Triggermatrix entspricht. Ein Triggern erfolgt dann nur unter der Bedingung, dass die von dem betreffenden Pixel registrierte Intensität des Abtaststrahls größer als ein vorgegenenes Vielfaches der von den benachbarten Pixeln registrierten Intensitäten ist. Damit wird sichergestellt, dass der Abtaststrahl innerhalb einer vorgegebenen Ungenauigkeit das Pixel der Triggermatrix trifft. Somit wird es möglich, das Punktraster des zu schreibenden Hologramms mit einer Genauigkeit von beispielsweise maximal-10% Abweichung von dem vorgegebenen Punktraster einzuhalten.

Bei einer weiteren Ausgestaltung der vorliegenden Erfindung wird für jedes Pixel der Triggermatrix ein Intensitätswert des Schreibstrahls zugeordnet und die Intensität des Schreibstrahls wird bei Erzeugen des einem Pixels zugeordneten Positionstriggersignals mit dem zugehörigen Intensitätswert gesteuert. Somit wird mit dem Erzeugen des Positionstriggersignals gleichzeitig ein Intensitätswert verknüpft, um die Intensität des Schreibstrahls einzustellen.

Wird die Triggermatrix beispielsweise in CMOS-Technik ausgebildet, so kann jedes Pixel mit einem im CMOS-Chip angeordneten Speicherelement verbunden werden. Beim Erzeugen des Triggersignals wird dann automatisch das zugeordnete Speicherelement ausgelesen und zusammen an die Steuerung der Intensität des Schreibstrahls übertragen. Auf diese Weise wird eine schnelle "intelligente" Triggermatrix erreicht, deren hohe Reaktionsgeschwindigkeit ein Triggern des Schreibstrahls im Bereich von 1 Mpixel/s ermöglicht.

Daneben kann ein CMOS-Detektor oder ein CCD-Array mit einem schnellen Speicherelement verknüpft sein, um nach dem Erzeugen des Triggersignals mittels des CMOS- bzw. CCD-Arrays über das Speicherelement den zugehörigen Intensitätswert zu ermitteln und innerhalb der vorgegebenen Übertragungszeit auf die Intensitätsteuerung des Schreibstrahls zu übertragen.

Bei einer weiteren bevorzugten Ausführungsform wird innerhalb des Schreibvorgangs eines digitalen Hologramms mit jedem Pixel der Triggermatrix maximal_nur einmal ein Positionstriggersignal erzeugt. Dadurch wird sichergestellt, dass der Schreibstrahl während des Schreibvorgangs nicht mehrfach denselben Punkt des digitalen Hologramms beschreibt. Doppel- oder Mehrfachbelichtungen werden dadurch wirksam vermieden, wenn ein Punkt mehrfach abgescannt wird. Dieses hat insbesondere den Vorteil, dass die Hologramme trotz der hohen Auflösung auch unter rauhen Umgebungsbedingungen zuverlässig geschrieben werden können. Beispielsweise wird der Einfluß von Vibrationen verringert.

Insbesondere bietet sich an, dass die Hologrammfläche bzw. die Triggermatrix vom Schreibstrahl bzw. vom Abtaststrahl mit einer vorgegebenen Mehrfachrate, auch Oversampling genannt, frei abgescannt werden. Die zweidimensional scannende Bewegung des Schreibstrahls unterliegt daher keiner vorgegebenen Führung. Das mehrfache Abtasten während des Schreibvorgangs stellt dabei sicher, dass ein Großteil oder im wesentlichen alle Punkte des Hologramms abgescannt werden. Für die Funktionalität des Hologramms kommt es nicht darauf an, dass alle Punkte geschrieben werden. Selbstverständlich ist jedoch die Qualität des Hologramms um so besser, je mehr Punkte des digitalen Rasters geschrieben worden sind. Auch das freie Scannen der Schreib- und Abtaststrahlen dient einer größeren Robustheit des Schreibvorgangs.

Das oben aufgezeigte technische Problem wird gemäß einer zweiten Lehre der vorliegenden Erfindung durch einen Lithographen mit den Merkmalen des Anspruches 9 gelöst.

Die zuvor beschriebene Funktionsweise der vorliegenden Erfindung sowie deren bevorzugte Ausgestaltungen können auch in vorteilhafter Weise bei einem scannenden, insbesondere konfokalen Mikroskop eingesetzt werden. Bei einem derartigen Mikroskop wird die zu untersuchende Oberfläche mit einem Lichtstrahl abgetastet bzw. beobachtet und die reflektierte Lichtintensität wird gemessen. Während des Abtastens der Oberfläche wird dann das Bild aus den gemessenen Intensitäten des reflektierten Lichts zusammengesetzt. Die Oberfläche wird also in einem Raster abgetastet, wie es zuvor beschrieben worden ist.

Vorliegend wird dazu im Strahlengang des reflektierten Strahls vor oder bevorzugt hinter dem Objektiv ein Strahlteiler angeordnet, um die reflektierte Strahlung auf einen optischen Sensor zu leiten. Dieser misst die reflektierte Intensität.

Mit einem derartigen Mikroskop werden das technische Problem gelöst, eine Oberfläche möglichst schnell und mit geringem Aufwand zu beobachten bzw. abzutasten. Dieses steht im Einklang mit der dem zuvor beschriebenen Lithographen zugrundeliegenden technische Problem. Die zuvor für den Lithographen beschriebenen Vorteile werden ebenfalls bei einem derartigen Mikroskop erreicht.

Nachfolgend wird die Erfindung anhand von Ausführungsbeispielen mit Bezug auf die beigefügte Zeichnung näher erläutert wird. In der Zeichnung zeigen
- Fig. 1: ein erstes Ausführungsbeispiel eines erfindungsgemäßen Lithographen,
- Fig. 2: ein zweites Ausführungsbeispiel eines erfindungsgemäßen Lithographen,
- Fig. 3: ein dritte Ausführungsbeispiel eines erfindungsgemäßen Lithographen in einer Draufsicht,
- Fig. 4: der in Fig. 3 gezeigte Lithograph in einer Seitenansicht,
- Fig. 5: ein viertes Ausführungsbeispiel eines erfindungsgemäßen Lithographen in einer Draufsicht,
- Fig. 6: der in Fig. 5 gezeigte Lithograph in einer Seitenansicht und
- Fig. 7: ein erfindungsgemäßes Mikroskop mit einem Aufbau, der im wesentlichen dem Aufbau des in Fig. 1 dargestellten Lithographen entspricht.

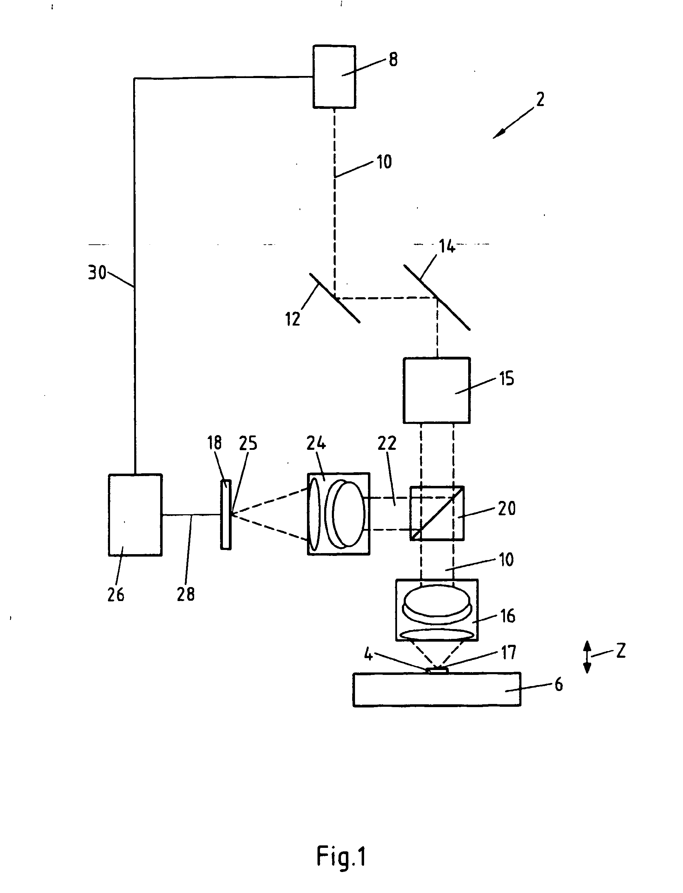

Fig. 1 zeigt ein erstes Ausführungsbeispiel eines erfindungsgemäßen Lithographen 2 zum Herstellen digitaler Hologramme in einem Speichermedium 4, das auf einem Träger 6 angeordnet ist. Eine Lichtquelle 8 zum Erzeugen eines Schreibstrahls 10 weist bevorzugt einen Laser oder eine Laserdiode auf, so daß der Schreibstrahl 10 als Laserstrahl ausgebildet ist.

Der Lithograph 2 weist weiterhin Antriebsmittel zum zweidimensionalen Bewegen des Schreibstrahls 10 relativ zum Speichermedium 4 auf, die als galvanisch angetriebene Scanspiegel 12 und 14 ausgebildet sind und in zwei im wesentlichen orthogonal zueinander ausgerichtete x- und y-Richtungen den Schreibstrahl ablenken. Die x-Richtung verläuft beispielsweise in der Bildebene der Fig. 1 und die y-Richtung verläuft in einer Ebene senkrecht zur Bildebene. Die Spiegel 12 und 14 stellen also eine x/y-Scanspiegelanordnung dar. Anstelle eines der beiden oder beider galvanischen Scanspiegel können auch drehbare Polygonspiegel eingesetzt werden.

Optional ist weiterhin ein Strahlaufweiter bzw. Kollimator 15 im Strahlengang hinter den Scanspiegeln 12 und 14 angeordnet, um einen aufgeweiteten Schreibstrahl 10 zu erzeugen.

Ein erstes Objektiv 16 fokussiert den Schreibstrahl 10 auf das zu beschreibende Speichermedium 4, so daß im Fokus 17 in Abhängigkeit von der gebündelten Intensität des Schreibstrahls 10 die optische Eigenschaft des Speichermediums 4 verändert wird oder unverändert bleibt.

Erfindungsgemäß ist eine zweidimensionale Triggermatrix 18 vorgesehen, auf die ein durch einen Strahlteiler 20 aus dem Schreibstrahl 10 ausgekoppelter Abtaststrahl 22 mit einem zweiten Objektiv 24 in einem Fokus 25 fokussiert wird.

Beide Objektive 16 und 24 weisen jeweils drei Linsen eines fokussierenden Linsensystems auf. Jedoch kommt es auf die genaue Ausgestaltung der Objektive 16 und 24 nicht an. Die Objektive 16 und 24 müssen jedoch gewährleisten, dass deren Winkelablenkungen in x-/y-Richtung linear voneinander abhängen, da ansonsten keine Kopplung zwischen den Bewegungen der Foki 17 und 25 besteht.

Wie sich aus dem Aufbau des Lithographen 2 gemäß Fig. 1 ergibt, bewegen die Antriebsmittel, also die Scanspiegel 12 und 14 nicht nur den Schreibstrahl 10, sondern auch den Abtaststrahl 22. Denn der Strahlteiler 20 ist im Strahlengang des Schreibstrahls 10 hinter den Scanspiegeln 12 und 14 angeordnet. Somit bewegt sich der Abtaststrahl 22 in gleicher Weise zweidimensional wie der Schreibstrahl 10, so daß der Abtaststrahl 22 relativ zur Oberfläche der Triggermatrix 18 bewegt wird. Daraus ergibt sich, dass die Bewegung des Abtaststrahls 22 mit der Bewegung des Schreibstrahls 10 gekoppelt ist.

Weiterhin sind Steuermittel 26 über eine Leitung 28 mit der Triggermatrix 18 verbunden, um ein Triggersignal zum Steuern der Intensität des Schreibstrahls 10 über eine Leitung 30 auf die Lichtquelle 8 zu übertragen. Die Steuermittel 26 können dabei als schneller Speicherchip oder als Computer ausgebildet sein. Durch das über die Leitung 30 übermittelte Signal wird der Schreibstrahl 10 in Abhängigkeit von der Position des Fokus 25 des Abtaststrahls 22 auf der Triggermatrix 18, die mit der Position des Fokus 17 des Schreibstrahls 10 auf dem Speichermedium 4 gekoppelt ist, moduliert.

Mit anderen Worten wird der Schreibstrahl 10 für ein Schreiben von Hologrammpunkten mit zwei oder mehr verschiedenen Intensitätswerten eingestellt. Bei einem binären Schreiben wird die Intensität zwischen zwei verschiedenen Werten hin- und hergeschaltet, je nach dem, ob ein Punkt geschrieben werden soll oder nicht. Ebenso ist ein Schreiben von Hologrammpunkten mit einer Grauwertabstufung möglich und sinnvoll. Für die Erfassung des Fokus 25 auf der Triggermatrix 18 ist es allerdings erforderlich, dass der niedrigere oder niedrigste Intensitätswert des Schreibstrahls 10 nicht gleich Null ist, da der Abtaststrahl 22 als Teil des Schreibstrahls 10 ausgekoppelt wird.

Weiterhin wird bei dem in Fig. 1 dargestellten Aufbau des Lithographen 2 ein längenbezogenes Übersetzungsverhältnis zwischen der Bewegung des Schreibstrahls 10 auf dem Speichermedium 4 des Abtaststrahls 22 auf der Triggermatrix 18 vorgegeben. Dieses wird durch unterschiedliche Brennweiten der beiden Objektive 16 und 24 realisiert. Ist beispielsweise die Brennweite des ersten Objektives 16 um einen Faktor 10 kleiner als die Brennweite des zweiten Objektivs 24, so ist die Bewegung des Fokus 25 des Abtaststrahls 22 auf der Triggermatrix 18 um den gleichen Faktor 10 mal größer als die Bewegung des Fokus 17 auf der Oberfläche des Speichermediums 4. In der Fig. 1 ist aus Platzgründen lediglich ein Brennweitenverhältnis von ca. 2 dargestellt. Dieses verdeutlich aber, dass es nicht auf ein bestimmtes Verhältnis bei der vorliegenden Ausgestaltung der Erfindung ankommt.

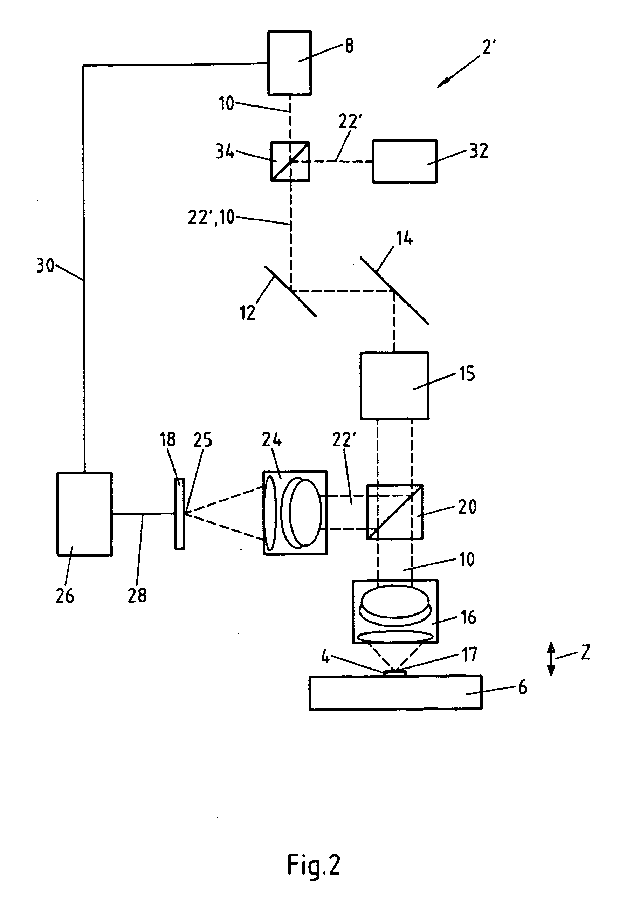

In Fig. 2 ist ein zweites Ausführungsbeispiel eines erfindungsgemäßen Lithographen 2' dargestellt, das in vielen Bestandteilen mit dem in Fig. 1 dargestellten Ausführungsbeispiel übereinstimmt. Daher werden gleiche Bestandteile mit gleichen Bezugszeichen verwendet.

Im Unterschied zum ersten Ausführungsbeispiel wird der Abtaststrahl 22' nicht als Teil des Schreibstrahls 10 ausgekoppelt. Statt dessen erzeugt eine zweite Lichtquelle 32 den Abtaststrahl 22', der mit einem Strahlteiler 34 in den Strahlengang des Schreibstrahls 10 vor dem ersten Scanspiegel 12 eingekoppelt wird. Der Abtaststrahl 22' weist eine vom Schreibstrahl 10 abweichende Wellenlänge oder Polarisation auf, so daß der Strahlteiler 34 als dichroitischer oder polarisierender Strahlteiler ausgebildet ist. Der Strahlteiler 20 ist dann entsprechend dichroitisch oder polarisierend ausgebildet, um den Abtaststrahl 22' aus dem gemeinsamen Strahlengang auszukoppeln.

Der Abtaststrahl 22' ist also unabhängig von der Intensitätsmodulation des Schreibstrahls 10, so dass dieser auch ausgeschaltet, also mit einer Intensität gleich Null eingestellt werden kann.

Da ansonsten die Funktionsweise des in Fig. 2 dargestellten Ausführungsbeispiels gleich dem ersten Ausführungsbeispiel ist, wird auf die oben angegebene Beschreibung verwiesen.

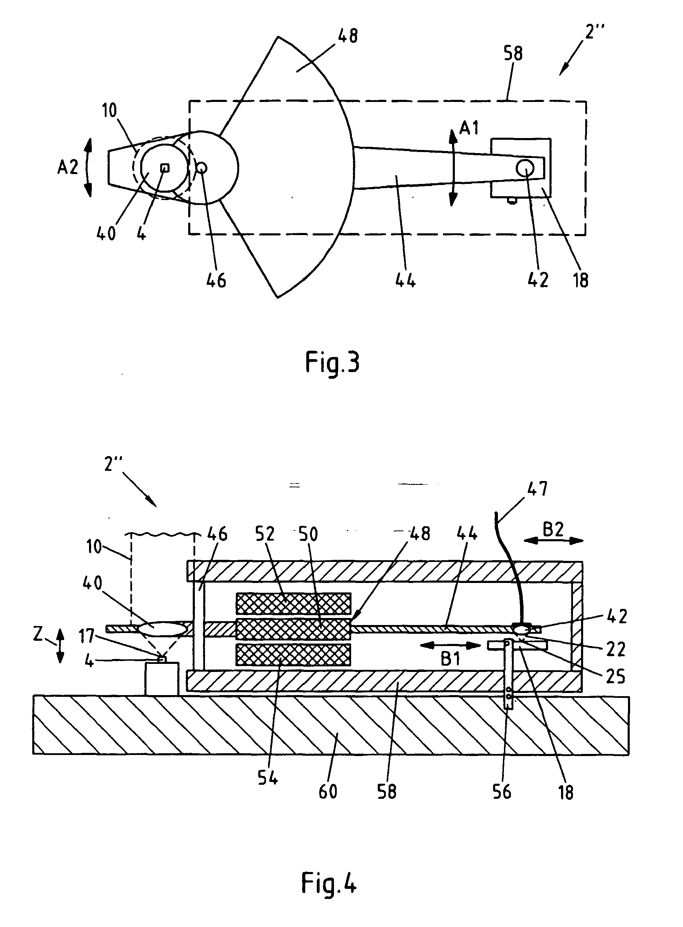

In den Fig. 3 und 4 ist ein drittes Ausführungsbeispiel eines erfindungsgemäßen Lithographen 2" dargestellt. Der Aufbau des Lithographen 2" ist grundsätzlich von dem in den Fig. 1 und 2 dargestellten Aufbauten verschieden. Denn beim Lithographen 2" werden nicht der Schreibstrahl und der Abtaststrahl bei ruhenden Objektiven bewegt, sondern das zweidimensionale Bewegen der Fokuspunkte erfolgt durch ein Verstellen der Objektive, während der Schreibstrahl und der Abtaststrahl vor den Objektiven im wesentlichen räumlich konstant verlaufen.

Wie die Fig. 3 und 4 zeigen, ist das erste Objektiv als Schreiblinse 40 und das zweites Objektiv als Abtastlinse 42 ausgebildet, die an einem gemeinsamen Haltearm 44 befestigt sind. Der Haltearm 44 ist um eine Drehachse 46 drehbar gelagert.

Der mit gestrichelten Linien gezeichnete Schreibstrahl 10 wird in einer zuvor beschriebenen Weise mit Hilfe einer Lichtquelle erzeugt, was nicht im Detail in den Fig. 3 und 4 dargestellt ist. Der Schreibstrahl 10 weist einen Durchmesser auf, der größer als die Apertur der Schreiblinse 40 ist. Daher fokussiert die Schreiblinse 40 nur einen Teil des Abtaststrahls 10. Die Schreiblinse 40 kann also innerhalb des von dem Schreibstrahl eingenommenen Bereiches bewegt werden, ohne dass es zu einem unterschiedlichen Ausleuchten der Schreiblinse 40 kommt. Dadurch wird, eine gleichmäßige Intensitätsverteilung innerhalb des Profils des Schreibstrahls 10 vorausgesetzt, eine gleiche Intensität im Fokus 17 gewährleistet.

Der Abtaststrahl 22 wird mit Hilfe einer Fiber 47 der Abtastlinse 42 zugeführt, wobei die Lichtquelle zum Erzeugen des Abtaststrahls 22 nicht in den Fig. 3 und 4 dargestellt ist. Die Abtastlinse 42 fokussiert den aus der Fiber 47 ausgekoppelten Abtaststrahl 22 im Fokus 25 auf der Oberfläche der Triggermatrix 18.

Eine erste Antriebsvorrichtung in Form eines quasilinearen Linearmotors 48 erzeugt eine oszillierende Drehbewegung des Haltearms 44. Dazu weist der Linearmotor 48 einen mit dem Haltearm verbundenen Stator 50 und darüber und/oder darunter angeordnete Magnetspulenanordnungen 52 und 54 auf. Diese Anordnung ist an sich aus dem Stand der Technik der Lesekopfantriebe für Computerfestplatten bekannt. Jedenfalls kann durch einen derartigen Linearmotor 48 aufgrund der geringen Masse und des starken Antriebes eine oszillierende Bewegung des Haltearms 44 im Bereich von 5-10 kHz erzeugt werden.

Durch den Linearmotors 48 wird eine laterale Bogenbewegung der Schreiblinse 40 und der Abtastlinse 42 erzeugt, die mit einer weiteren im wesentlichen quer dazu verlaufenden Bewegung zu einer zweidimensional scannenden Bewegung überlagert werden kann. Dadurch wird ein Abscannen des zu beschreibenden Bereiches des Speichermediums 4 sowie der Triggermatris 18 durch die Foki 17 und 25 ermöglicht.

Weiterhin ist in den Fig. 3 und 4 dargestellt, dass Schreiblinse 40 in einem ersten Abstand zur Drehachse 46 des Haltearms 44 und die Abtastlinse 42 in einem zweiten Abstand zur Drehachse 46 angeordnet sind, wobei der zweite Abstand größer als der erste Abstand ist. Daher kommt es bei der lateralen Bogenbewegung beider Linsen 40 und 42 zu einer Übersetzung der Bewegung in dem Verhältnis, wie die Linsen 40 und 42 zur Drehachse 44 beabstandet sind. Bevorzugt ist dabei, dass der Abstand der Abtastlinse 42 um den Faktor 10 größer als der Abstand der Schreiblinse 40 zur Drehachse 46 ist. Dieses entspricht dem oben angegebenen Zahlenbeispiel. Die beiden lateralen Bogenbewegungen sind mit den Doppelpfeilen A1 und A2 in Fig. 3 gekennzeichnet.

Die Schreiblinse 40 und die Abtastlinse 42 sind am Haltearm 44 auf gegenüberliegenden Seiten der Drehachse 46 angeordnet. Dadurch ist es möglich, den gesamten Aufbau des Haltearmes 44 und des Antriebes 48 sowie einen nachfolgend beschriebenen Hebelmechanismus 56 in einem Gehäuse 58 anzuordnen, während die Schreiblinse 40 außerhalb des Gehäuses 58 angeordnet ist. Dadurch wird das Zuführen des Speichermediums 4 unterhalb der Schreiblinse 40 vereinfacht. Zudem wird das Abtasten der Triggermatrix 18 von der Umgebung abgeschirmt, so daß eine exakte Relativbewegung ohne größere Einflüsse von außen realisiert werden kann.

Die Bewegung quer zur lateralen Bogenbewegung wird durch eine zweite Antriebsvorrichtung zum Erzeugen einer linearen Bewegung der Triggermatrix 18 und des Drehlagers 46 des Haltearms 44 relativ zum Speichermedium 4 erzeugt. Der Antrieb selbst ist nicht dargestellt, jedoch wird über eine schematisch dargestellte Hebelanordnung 56 sowohl die Triggermatrix 18 als auch ein die Anordnung des Haltearms 44 und Linearantrieb 48 umgebendes Gehäuse 58 gegenüber einem Untergrund 60 linear verstellt. Da die Ansatzpunkte des Hebels 56 an der Triggermatrix 18 und am Gehäuse 58 in unterschiedlichen Entfernungen vom mit dem Untergrund 60 verbundenen Drehpunkt angeordnet sind, findet eine durch die unterschiedlichen Entfernungen vorgegebene Übersetzung der Bewegung des Haltearms 44 und der Triggermatrix 18, also der Foki 17 und 25 statt. Die unterschiedlichen großen linearen Bewegungen sind in Fig. 4 mit den Doppelpfeilen B1 und B2 dargestellt. Anstelle des schematisch dargestellten Hebelmechanismus lassen sich an sich bekannte schlupffreie Getriebeübersetzungen oder hydropneumatische Übersetzungen einsetzen.

Somit wird erreicht, dass die zweiten Antriebsmittel eine mechanische Übersetzung realisieren, die ein Bewegungsverhältnis zwischen der Bewegung der Triggermatrix 18 und des Drehlagers 46 des Haltearms 44 relativ zum Speichermedium 4 bewirkt.

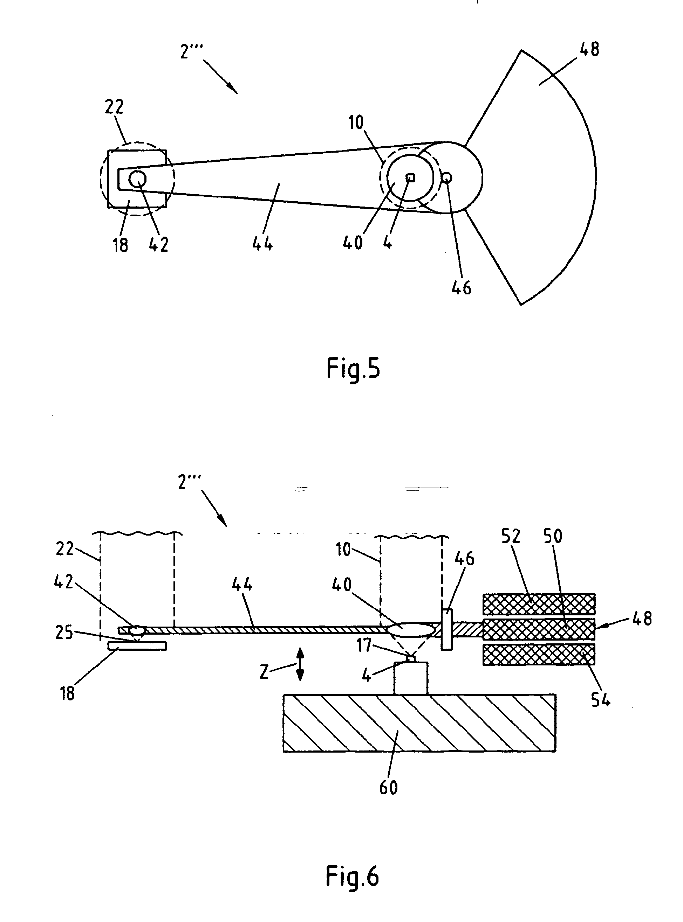

Die Fig. 5 und 6 zeigen ein viertes Ausführungsbeispiel eines erfindungsgemäßen Lithographen 2"', der prinzipiell dem in den Fig. 3 und 4 dargestellten Ausführungsbeispiel entspricht. Daher bezeichnen auch hier gleiche Bezugszeichen übereinstimmende Bestandteile. Es werden auch nur die vom dritten Ausführungsbeispiel abweichenden Merkmale erläutert.

Das zweite Objektiv, also die Abtastlinse 42, fokussiert einen Teil des aufgeweiteten Abtaststrahls 22 auf die Oberfläche der Triggermatrix 18. Der Abtaststrahl 22 wird also nicht über eine Fiber zugeführt, sondern frei auf den Bereich der Triggermatrix 18 gerichtet. Die Abtastlinse 42 fokussiert daher einen Teil des Abtaststrahls 22 auf die Triggermatrix 18. Da die Intensität im Fokus deutlich größer als im unfokussierten Abtaststrahl 22 ist, braucht die Triggermatrix 18 nicht abgeschirmt zu werden. Dieses hat den Vorteil, dass die zu bewegende Masse des Haltearms 44 nicht durch eine zusätzliche im Bereich der Abtastlinse 42 angeordnete Abschirmung vergrößert wird.

Darüber hinaus sind bei dem in den Fig. 5 und 6 dargestellten Ausführungsbeispiel die beiden Linsen 40 und 42 auf der gleichen Seite der Drehachse 46 am Haltearm 44 befestigt.

In allen Ausführungsbeispielen des erfindungsgemäßen Lithographen ist eine Triggermatrix 18 vorgesehen, deren Eigenschaften sich allgemein wie folgt darstellen lassen. Die Triggermatrix 18 ist als handelsübliches optoelektronisches Bauelement, beispielsweise als CMOS-Chip oder als CCD-Chip, ausgebildet und weist eine Mehrzahl von Pixeln auf. Diese sind in einem Raster, insbesondere orthogonalem Raster, angeordnet.

Wird ein Pixel mit einer ausreichenden Intensität beleuchtet, so erzeugt dieses Pixel ein Positionstriggersignal, das über die nur in den Fig. 1 und 2 dargestellte Leitung 28 auf die Steuermittel 26 weitergeleitet wird. Dort findet eine Auswertung des Triggersignals nach den Positionsdaten statt und ein entsprechendes Steuersignal wird an die Lichtquelle 8 zur Modulation der Intensität des Schreibstrahls 10 übertragen.

Ein CMOS-Chip weist auf seiner lichtempfindlichen Oberseite eine Matrix in einem Raster von 10 µm Abstand zwischen den einzelnen Pixeln auf, die durch "blinde" Stege bzw. Gaps voneinander getrennt sind. Die Stege sind derart ausgebildet, dass in Verbindung mit einem Schwellwert und dem Strahlprofil des Fokus 25 des Abtaststrahls 22 die Genauigkeitsanforderungen an den Triggerort erfüllt werden.

Weiterhin können die Steuermittel 26 zum Erzeugen eines Triggersignals Speichermittel aufweisen, die mit den Pixeln der Triggermatrix verbunden sind. In den Speichermitteln sind Intensitätswerte zu allen x/y-Positionen abgespeichert und werden beim entsprechenden Positionstriggersignal der Triggermatrix 18 ausgelesen und mit an die Steuerung der Lichtquelle 8 übermittelt. Im Falle eines CMOS-Chips können die Speichermittel mit den Pixeln direkt im Chip integriert angeordnet sein. Diese entsprechen dann "intelligenten" Pixeln.

Ein weiteres Merkmal der zuvor beschriebenen Ausgestaltungen des Lithographen besteht darin, dass der Abstand zwischen dem Speichermedium 4 und dem Objektiv 16 in den Fig. 1 und 2 bzw. der Schreiblinse 40 in den Fig. 4 und 6 variabel einstellbar ist. Dieses ist mit einem mit "Z" bezeichneten Doppelpfeil gekennzeichnet. Für ein Verstellen des Abstandes in z-Richtung sind in den Figuren nicht dargestellte Mittel vorgesehen. Dieses können jegliche linearen Verstellmittel sein, die motorisch oder per Hand angetrieben sein können. Durch ein Verstellen des Abstandes kann die Lage des Fokus im Speichermedium 4 in verschiedenen Tiefen angeordnet werden, ebenso ist eine Justierung des Fokus bei unterschiedlich dicken Speichermedien 4 möglich. Schließlich können mindestens zwei digitale Hologramme in verschiedenen Ebenen innerhalb des Speichermediums 4 eingeschrieben werden, um sogenannte Mehrschichthologramme zu erzeugen.

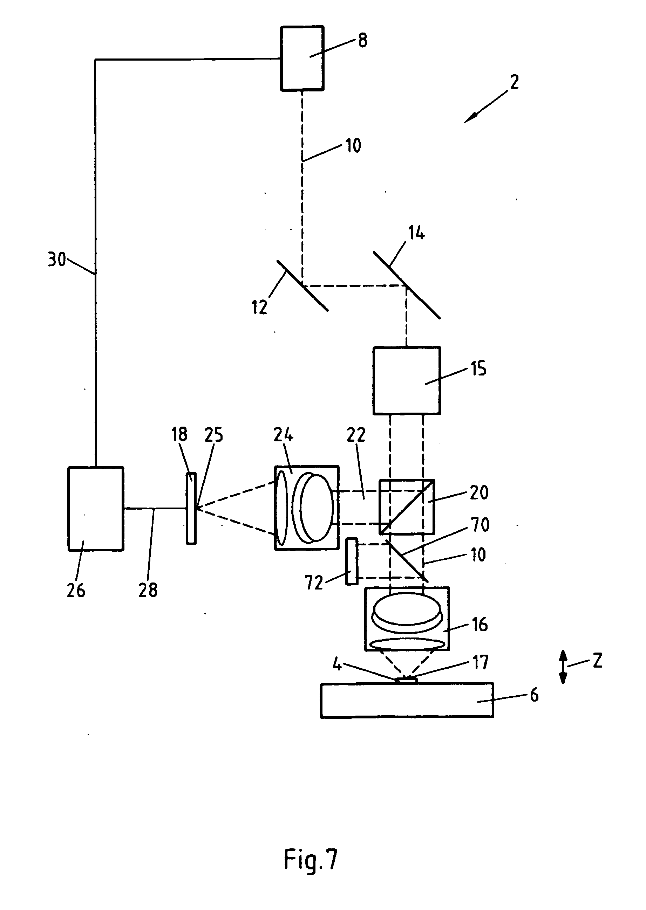

In Fig. 7 ist ein erfindungsgemäßes Mikroskop dargestellt, das in seinem Aufbau dem in Fig. 1 dargestellten Lithographen entspricht. Daher bezeichnen gleiche Bezugszeichen gleiche Bauteile wie im Zusammenhang mit Fig. 1 beschrieben worden sind, auch wenn im einzelne andere Bezeichnungen verwendet werden, die den Unterschied zwischen Schreiben und Beobachten kennzeichnen.

Zusätzlich zum in Fig. 1 dargestellten Aufbau ist im Strahlengang des von der Oberfläche reflektierten Lichtes hinter, also oberhalb des Objektivs 16 eine Umlenkebene 70 angeordnet. Diese kann durch einen halbdurchlässigen Spiegel oder einen Strahlteiler verwirklicht sein und beeinflusst nicht oder nur unwesentlich den Beobachtungsstrahl.

Die Umlenkebene 70 lenkt den reflektierten Strahl seitlich, in Fig. 7 nach links ab, so dass dieser auf einen Photosensor 72 trifft, der die Intensität des reflektierten Lichtes misst.

Durch das Verändern des Beobachtungsstrahls 10 relativ zum zu mikroskopierenden Objekt 4 wird dann die Oberfläche abgetastet und punktweise die Reflektivität gemessen. Somit kann eine Abbildung der abgetasteten Oberfläche zusammengesetzt werden.

Wird nun der von der Lichtquelle 8 emittierte Lichtstrahl, der bei dem Mikroskop als Beobachtungsstrahl bezeichnet werden kann, mit im wesentlichen gleich starker Intensität erzeugt, so ist die gemessene Intensität des reflektierten Strahls ein Maß für die Reflektivität der abgetasteten Oberfläche.

## Patentansprüche

1. Verfahren zum Herstellen digitaler Hologramme in einem Speichermedium,
- bei dem ein Schreibstrahl auf das Speichermedium fokussiert und zweidimensional relativ zum Speichermedium bewegt wird,
- bei dem ein Abtaststrahl auf eine eine Mehrzahl von Pixeln aufweisende Triggermatrix fokussiert und zweidimensional relativ zur Triggermatrix bewegt wird, wobei die Bewegung des Abtaststrahls mit der Bewegung des Schreibstrahls gekoppelt wird,
- bei dem dann, wenn der Abtaststrahl ein Pixel der Triggermatrix trifft, ein Positionstriggersignal erzeugt wird,
- bei dem mit Hilfe des Positionstriggersignals der Schreibstrahl aktiviert wird und an der dem Pixel der Triggermatrix zugeordneten Position auf dem Speichermedium ein Punkt des digitalen Hologramms erzeugt wird, und
- bei dem das Hologramm durch punktweises Einbringen von Strahlungsenergie geschrieben wird, wobei die Intensität des Schreibstrahls in Abhängigkeit von der Position des Schreibstrahls auf dem Speichermedium gesteuert wird.

2. Verfahren nach Anspruch 1,
bei dem der Abtaststrahl in einem vorgegebenen Bewegungsverhältnis zum Schreibstrahl bewegt wird.

3. Verfahren nach Anspruch 1 oder 2,
bei dem der Abtaststrahl auf eine Größe fokussiert wird, die maximal der Pixelabmessung der Triggermatrix entspricht.

4. Verfahren nach Anspruch 3,
bei dem ein Triggersignal dann erzeugt wird, wenn die von dem betreffenden Pixel registrierte Intensität des Abtaststrahls größer als ein vorgehendes Vielfaches der jeweils von den benachbarten Pixeln registrierten Intensitäten ist.

5. Verfahren nach einem der Ansprüche 1 bis 4,
bei dem für jedes Pixel der Triggermatrix ein Intensitätswert des Schreibstrahls zugeordnet wird und bei dem die Intensität des Schreibstrahls bei Erzeugen des einen Pixels zugeordneten Positionstriggersignals mit dem zugehörigen Intensitätswert gesteuert wird.

6. Verfahren nach einem der Ansprüche 1 bis 5,
bei dem innerhalb des Schreibvorgangs eines digitalen Hologramms mit jedem Pixel der Triggermatrix maximal nur einmal ein Positionstriggersignal erzeugt wird.

7. Verfahren nach Anspruch 6,
bei dem die Hologrammfläche bzw. die Triggermatrix vom Schreibstrahl bzw. vom Abtaststrahl mit einer vorgegebenen Mehrfachrate frei abgescannt werden.

8. Verfahren nach einem der Ansprüche 1 bis 7,
bei dem der Abstand zwischen dem Objektiv bzw. Schreiblinse und dem Speichermedium für ein Schreiben in verschiedenen Tiefen innerhalb des Speichermediums eingestellt wird.

9. Lithograph zum Herstellen digitaler Hologramme in einem Speichermedium (4), insbesondere zum Durchführen eines Verfahrens nach einem der Ansprüche 1 bis 7,
- mit einer Lichtquelle (8) zum Erzeugen eines Schreibstrahls (10),
- mit Antriebsmitteln (12, 14; 48, 56) zum zweidimensionalen Bewegen des Schreibstrahls (10) relativ zum Speichermedium (4) und
- mit einem ersten Objektiv (16; 40) zum Fokussieren des Schreibstrahls (10) auf das zu beschreibende Speichermedium (4),
**dadurch gekennzeichnet,**
- **dass** eine zweidimensionale Triggermatrix (18) vorgesehen ist,
- **dass** Mittel (32,34,20; 47) zum Erzeugen eines Abtaststrahls (22,22') vorgesehen sind,
- **dass** ein zweites Objektiv (24; 42) zum Fokussieren des Abtaststrahls (22,22') auf die Triggermatrix (18) vorgesehen ist,
- **dass** die Antriebsmittel (12,14; 48,56) den Abtaststrahl (22,22') zweidimensional relativ zur Oberfläche der Triggermatrix (18) bewegen, wobei die Bewegung des Abtaststrahls (22,22') mit der Bewegung des Schreibstrahls (10) gekoppelt ist, und
- **dass** Steuermittel (26) zum Erzeugen eines Triggersignals zum Steuern der Intensität des Schreibstrahls (10) mit der Triggermatrix (18) verbunden sind.

10. Lithograph nach Anspruch 9,
**dadurch gekennzeichnet,**
**dass** ein längenbezogenes Übersetzungsverhältnis zwischen der Bewegung des Abtaststrahls (22,22') auf der Triggermatrix (18) und des Schreibstrahls (10) auf dem Speichermedium (4) vorgegeben ist.

11. Lithograph nach Anspruch 9 oder 10,
**dadurch gekennzeichnet,**
- **dass** die Antriebsmittel (12,14) als x/y-Scanspiegelanordnung zum Bewegen des Schreibstrahls (10) ausgebildet sind und
- **dass** die Mittel zum Erzeugen des Abtaststrahls (22,22') Mittel (20) zum Auskoppeln eines Teils des Schreibstrahls (10) als Abtaststrahl (22,22') im Strahlengang des Schreibstrahls (10) hinter den Antriebsmitteln (12,14) aufweisen.

12. Lithograph nach Anspruch 11,
**dadurch gekennzeichnet,**
- **dass** die Mittel zum Erzeugen des Abtaststrahls (22') eine zweite Lichtquelle (32) zum Erzeugen eines Abtaststrahls (22') mit einer vom Schreibstrahl (10) abweichenden Wellenlänge oder Polarisation und
- Einkoppelmittel (34) zum Einkoppeln des Abtaststrahls (22') in den Strahlengang des Schreibstrahls (10) vor den Antriebsmitteln (12,14) aufweisen und
- **dass** die Mittel (20) zum Auskoppeln den Abtaststrahl (22') auskoppeln.

13. Lithograph nach Anspruch 11 oder 12,
**dadurch gekennzeichnet,**
**dass** die Brennweite des zweiten Objektivs (24) um einen vorgegebenen Faktor größer als die Brennweite des ersten Objektivs (16) ist

14. Lithograph nach Anspruch 9 oder 10,
**dadurch gekennzeichnet,**
- **dass** das erste Objektiv (40) und das zweites Objektiv (42) an einem drehbar gelagerten Haltearm (44) befestigt sind,
- **dass** eine erste Antriebsvorrichtung (48) zum Erzeugen einer oszillierenden Drehbewegung des Haltearms (44) vorgesehen ist und
- **dass** eine zweite Antriebsvorrichtung (56) zum Erzeugen einer linearen Bewegung der Triggermatrix (18) und des Drehlagers (46) des Haltearms (44) relativ zum Speichermedium (4) vorgesehen ist,
- wobei der Schreibstrahl (10) das erste Objektiv (40) innerhalb dessen Bewegungsbereiches vollständig ausleuchtet.

15. Lithograph nach Anspruch 14,
**dadurch gekennzeichnet,**
**dass** eine Faser (47) zum Zuführen des Abtaststrahls (22) mit dem zweiten Objektiv (42) verbunden ist.

16. Lithograph nach Anspruch 14,
**dadurch gekennzeichnet,**
**dass** das zweite Objektiv (42) einen Teil des aufgeweiteten Abtaststrahls (22) auf die Oberfläche der Triggermatrix (18) fokussiert.

17. Lithograph nach einem der Ansprüche 14 bis 16,
**dadurch gekennzeichnet,**
**dass** das erste Objektiv (40) in einem ersten Abstand zur Drehachse (46) des Haltearms (44) und das zweite Objektiv (42) in einem zweiten Abstand zur Drehachse (46) angeordnet sind, wobei der zweite Abstand größer als der erste Abstand ist.

18. Lithograph nach Anspruch.17,
**dadurch gekennzeichnet,**
**dass** das erste Objektiv (40) und das zweite Objektiv (42) am Haltearm (44) auf gegenüberliegenden Seiten der Drehachse (46) angeordnet sind.

19. Lithograph nach einem der Ansprüche 14 bis 18,
**dadurch gekennzeichnet,**
**dass** die zweiten Antriebsmittel (56) eine mechanische Übersetzung aufweisen, die ein Bewegungsverhältnis zwischen der Bewegung der Triggermatrix (18) und des Drehlagers (46) des Haltearms (44) relativ zum Speichermedium (4) bewirken.

20. Lithograph nach einem der Ansprüche 9 bis 19,
**dadurch gekennzeichnet,**
**dass** die Triggermatrix (18) eine Mehrzahl von Pixeln aufweist.

21. Lithograph nach Anspruch 20,
**dadurch gekennzeichnet,**
**dass** die Pixel in einem Raster, insbesondere orthogonalem Raster, angeordnet sind.

22. Lithograph nach Anspruch 20 oder 21,
**dadurch gekennzeichnet,**
**dass** die Triggermatrix (18) als optoelektronischer Wandler, insbesondere als CCD-Chip oder als CMOS-Chip ausgebildet ist.

23. Lithograph nach einem der Ansprüche 9 bis 22,
**dadurch gekennzeichnet,**
**dass** die Steuermittel (26) zum Erzeugen eines Triggersignals Speichermittel aufweisen, die mit den Pixeln der Triggermatrix (18) verbunden sind.

24. Lithograph nach einem der Ansprüche 9 bis 23,
**dadurch gekennzeichnet,**
**dass** Mittel zum Verstellen des Abstandes zwischen dem Speichermedium (4) und dem Objektiv (16) bzw. der Schreiblinse (40) vorgesehen sind.

25. Mikroskop zum Abtasten eines Objektes (4),
- mit einer Lichtquelle (8) zum Erzeugen eines Beobachtungsstrahls (10),
- mit Antriebsmitteln (12,14; 48,56) zum zweidimensionalen Bewegen des Beobachtungsstrahls (10) relativ zum-Objekt (4) und
- mit einem ersten Objektiv (16) zum Fokussieren des Beobachtungsstrahls (10) auf das Objekt (4),
**dadurch gekennzeichnet,**
- **dass** eine zweidimensionale Triggermatrix (18) vorgesehen ist,
- **dass** Mittel (32,34,20) zum Erzeugen eines Abtaststrahls (22,22') vorgesehen sind,
- **dass** ein zweites Objektiv (24) zum Fokussieren des Abtaststrahls (22,22') auf die Triggermatrix (18) vorgesehen ist,
- **dass** die Antriebsmittel (12,14; 48,56) den Abtaststrahl (22,22') zweidimensional relativ zur Oberfläche der Triggermatrix (18) bewegen, wobei die Bewegung des Abtaststrahls (22,22') mit der Bewegung des Beobachtungsstrahls (10) gekoppelt ist.

26. Mikroskop nach Anspruch 25 mit den Merkmalen eines oder mehrerer Ansprüche 9 bis 24.

## Claims

1. A method of producing digital holograms in a storage medium,
- in which a write beam is focused onto the storage medium and moved two-dimensionally relative to the storage medium,
- in which a scanning beam is focused onto a trigger matrix having a plurality of pixels and moved two-dimensionally relative to the trigger matrix, the movement of the scanning beam being coupled with the movement of the write beam,
- in which, when the scanning beam strikes a pixel belonging to the trigger matrix, a position trigger signal is generated,
- in which, with the aid of the position trigger signal, the write beam is activated and, at the position associated with the pixel belonging to the trigger matrix, a point of the digital hologram is produced on the storage medium, and
- in which the hologram is written by introducing radiation energy point by point, the intensity of the write beam being controlled as a function of the position of the write beam on the storage medium.

2. The method as claimed in claim 1, in which the scanning beam is moved in a predefined movement relationship with the write beam.

3. The method as claimed in claim 1 or 2, in which the scanning beam is focused to a size which corresponds at most to the pixel dimension of the trigger matrix.

4. The method as claimed in claim 3, in which a trigger signal is generated when the intensity of the scanning beam registered by the relevant pixel is greater than a given multiple of the intensities respectively registered by the adjacent pixels.

5. The method as claimed in one of claims 1 to 4, in which, for each pixel, an intensity value of the write beam is assigned to the trigger matrix, and in which the intensity of the write beam is controlled with the associated intensity value during the generation of the position trigger signal assigned to a pixel.

6. The method as claimed in one of claims 1 to 5, in which, within the writing operation of a digital hologram with each pixel of the trigger matrix, a position trigger signal is generated at most only once.

7. The method as claimed in claim 6, in which the hologram area and the trigger matrix are scanned freely by the write beam and by the scanning beam at a predefined multiple rate.

8. The method as claimed in one of claims 1 to 7, in which the distance between the objective or writing lens and the storage medium is adjusted for writing at different depths within the storage medium.

9. A lithograph for producing digital holograms in a storage medium (4), in particular for implementing a method as claimed in one of claims 1 to 7,
- having a light source (8) for producing a write beam (10),
- having drive means (12, 14; 48, 56) for the two-dimensional movement of the write beam (10) relative to the storage medium (4) and
- having a first objective (16; 40) for focusing the write beam (10) onto the storage medium (4) to be written,
**characterized**
- **in that** a two-dimensional trigger matrix (18) is provided,
- **in that** means (32, 34, 20; 47) of producing a scanning beam (22, 22') are provided,
- **in that** a second objective (24; 42) for focusing the scanning beam (22, 22') onto the trigger matrix (18) is provided,
- **in that** the drive means (12, 14; 48, 56) move the scanning beam (22, 22') two-dimensionally relative to the surface of the trigger matrix (18), the movement of the scanning beam (22, 22') being coupled with the movement of the write beam (10), and
- **in that** control means (26) for generating a trigger signal to control the intensity of the write beam (10) are connected to the trigger matrix (18).

10. The lithograph as claimed in claim 9, **characterized in that** a length-based step-up ratio between the movement of the scanning beam (22, 22') on the trigger matrix (18) and of the write beam (10) on the storage medium (4) is predefined.

11. The lithograph as claimed in claim 9 or 10,
**characterized**
- **in that** the drive means (12, 14) are formed as an x/y scanning mirror arrangement for moving the write beam (10) and
- **in that** the means of producing the scanning beam (22, 22') have means (20) for coupling part of the write beam (10) out as a scanning beam (22, 22') in the beam path of the write beam (10) behind the drive means (12, 14).

12. The lithograph as claimed in claim 11, **characterized**
- **in that** the means of producing the scanning beam (22')
- have a second light source (32) for producing a scanning beam (22') with a wavelength or polarization differing from the write beam (10) and
- input coupling means (34) for coupling the scanning beam (22') into the beam path of the write beam (10) in front of the drive means (12, 14) and
- **in that** the output coupling means (20) couple out the scanning beam (22').

13. The lithograph as claimed in claim 11 or 12, **characterized in that** the focal length of the second objective (24) is greater by a predefined factor than the focal length of the first objective (16).

14. The lithograph as claimed in claim 9 or 10,
**characterized**
- **in that** the first objective (40) and the second objective (42) are fixed to a rotatably mounted holding arm (44),
- **in that** a first drive device (48) for producing an oscillating rotational movement of the holding arm (44) is provided and
- **in that** a second drive device (56) for producing a linear movement of the trigger matrix (18) and of the rotary bearing (46) of the holding arm (44) relative to the storage medium (4) is provided,
- the write beam (10) illuminating the first objective (40) completely within its movement range.

15. The lithograph as claimed in claim 14, **characterized in that** a fiber (47) is connected to the second objective (42) in order to supply the scanning beam (22).

16. The lithograph as claimed in claim 14, **characterized in that** the second objective (42) focuses part of the widened scanning beam (22) onto the surface of the trigger matrix (18).

17. The lithograph as claimed in one of claims 14 to 16, **characterized in that** the first objective (40) is arranged at a first distance from the axis of rotation (46) of the holding arm (44), and the second objective (42) is arranged at a second distance from the axis of rotation (46), the second distance being greater than the first distance.

18. The lithograph as claimed in claim 17, **characterized in that** the first objective (40) and the second objective (42) are arranged on the holding arm (44) on opposite sides of the axis of rotation (46).

19. The lithograph as claimed in one of claims 14 to 18, **characterized in that** the second drive means (56) have a mechanical step up which bring [sic] about a movement ratio between the movement of the trigger matrix (18) and of the rotary bearing (46) of the holding arm (44) relative to the storage medium (4).

20. The lithograph as claimed in one of claims 9 to 19, **characterized in that** the trigger matrix (18) has a plurality of pixels.

21. The lithograph as claimed in claim 20, **characterized in that** the pixels are arranged in a pattern, in particular an orthogonal pattern.

22. The lithograph as claimed in claim 20 or 21, **characterized in that** the trigger matrix (18) is formed as an optoelectronic converter, in particular as a CCD chip or as a CMOS chip.

23. The lithograph as claimed in one of claims 9 to 22, **characterized in that** the control means (26) for generating a trigger signal have storage means which are connected to the pixels of the trigger matrix (18).

24. The lithograph as claimed in one of claims 9 to 23, **characterized in that** means are provided for adjusting the distance between the storage medium (4) and the objective (16) or the writing lens (40).

25. A microscope for scanning an object (4),
- having a light source (8) for producing an observation beam (10),
- having drive means (12, 14; 48, 56) for the two-dimensional movement of the observation beam (10) relative to the object (4) and
- having a first objective (16) for focusing the observation beam (10) onto the object (4),
**characterized**
- **in that** a two-dimensional trigger matrix (18) is provided,
- **in that** means (32, 34, 20) of producing a scanning beam (22, 22') are provided,
- **in that** a second objective (24) for focusing the scanning beam (22, 22') onto the trigger matrix (18) is provided,
- **in that** the drive means (12, 14; 48, 56) move the scanning beam (22, 22') two-dimensionally relative to the surface of the trigger matrix (18), the movement of the scanning beam (22, 22') being coupled with the movement of the observation beam (10).

26. The microscope as claimed in claim 25, having the features of one of claims 9 to 24.

## Revendications

1. Procédé de fabrication d'hologrammes numériques dans un support mémoire
- dans lequel un faisceau d'écriture est focalisé sur le support mémoire et est déplacé dans deux dimensions par rapport au support mémoire,
- dans lequel un faisceau de lecture est focalisé sur une matrice de déclenchement présentant une pluralité de pixels et est déplacé dans deux dimensions par rapport à la matrice de déclenchement, le déplacement du faisceau de lecture étant couplé au déplacement du faisceau d'écriture,
- dans lequel, ensuite, lorsque le rayon de lecture rencontre un pixel de la matrice de déclenchement, un signal de déclenchement de position est généré,
- dans lequel, à l'aide du signal de déclenchement de position, le faisceau d'écriture est activé et un point de l'hologramme numérique est généré dans la position affectée au pixel de la matrice de déclenchement sur le support mémoire, et
- dans lequel l'hologramme est écrit par apport ponctuel d'énergie rayonnante, l'intensité du faisceau d'écriture étant commandée en fonction de la position du faisceau d'écriture sur le support mémoire.

2. Procédé selon la revendication 1, dans lequel le faisceau de lecture est déplacé dans un rapport de déplacement prédéterminé par rapport au faisceau d'écriture.

3. Procédé selon la revendication 1 ou 2, dans lequel le faisceau de lecture est focalisé à une taille qui correspond au maximum à la dimension en pixels de la matrice de déclenchement.

4. Procédé selon la revendication 3, dans lequel un signal de déclenchement est généré lorsque l'intensité du faisceau de lecture enregistrée par le pixel correspondant est supérieure à un multiple précédent des intensités enregistrées respectivement par les pixels voisins.

5. Procédé selon l'une quelconque des revendications 1 à 4, dans lequel une valeur d'intensité du faisceau d'écriture est affectée à chaque pixel de la matrice de déclenchement et dans lequel l'intensité du faisceau d'écriture, lors de la génération du signal de déclenchement de position affecté à un pixel, est commandée par la valeur d'intensité afférente.

6. Procédé selon l'une quelconque des revendications 1 à 5, dans lequel, au sein de l'opération d'écriture d'un hologramme numérique, il n'est produit, avec chaque pixel de la matrice de déclenchement, au maximum qu'un signal de déclenchement de position.

7. Procédé selon la revendication 6, dans lequel la surface de l'hologramme ou la matrice de déclenchement est scannée librement par le faisceau d'écriture ou par le faisceau de lecture avec un débit multiple prédéterminé.

8. Procédé selon l'une quelconque des revendications 1 à 7, dans lequel on ajuste la distance entre l'objectif ou la lentille d'écriture et le support mémoire pour une écriture à différentes profondeurs à l'intérieur du support mémoire.

9. Dispositif lithographique pour produire des hologrammes numériques dans un support mémoire (4), en particulier pour réaliser un procédé selon l'une quelconque des revendications 1 à 7,
- avec une source lumineuse (8) pour générer un faisceau d'écriture (10),
- avec des moyens d'entraînement (12,14; 48,56) pour le déplacement bidimensionnel du faisceau d'écriture (10) par rapport au support mémoire (4) et
- avec un premier objectif (16; 40) pour focaliser le rayon d'écriture (10) sur le support mémoire inscriptible (4),
**caractérisé en ce que**
- il est prévu une matrice de déclenchement bidimensionnelle (18),
- il est prévu des moyens (32,34,20; 47) pour générer un faisceau de lecture (22,22'),
- il est prévu un second objectif (24; 42) pour focaliser le faisceau de lecture (22, 22') sur la matrice de déclenchement (18),
- les moyens d'entraînement (12,14; 48,56) déplacent le faisceau de lecture (22,22') dans deux dimensions par rapport à la surface de la matrice de déclenchement (18), le déplacement du faisceau de lecture (22,22') étant couplé au déplacement du faisceau d'écriture (10), et
- les moyens de commande (26) pour générer un signal de déclenchement sont raccordés à la matrice de déclenchement (18) pour commander l'intensité du faisceau d'écriture (10).

10. Dispositif lithographique selon la revendication 9, **caractérisé en ce qu'**un rapport de démultiplication linéique entre le déplacement du faisceau de lecture (22,22') sur la matrice de déclenchement (18) et celui du faisceau d'écriture (10) sur le support mémoire (4) est prédéterminé.

11. Dispositif lithographique selon la revendication 9 ou 10,
**caractérisé en ce que**
- les moyens d'entraînement (12,14) se présentent sous la forme d'un dispositif à miroir de balayage x/y pour déplacer le faisceau d'écriture (10) et
- les moyens pour générer le faisceau de lecture (22,22') présentent des moyens (20) pour désaccoupler une partie du faisceau d'écriture (10) lorsque le faisceau de lecture (22,22') se trouve dans la trajectoire du faisceau d'écriture (10) derrière les moyens d'entraînement (12,14).

12. Dispositif lithographique selon la revendication 11,
**caractérisé en ce que**
- les moyens pour générer le faisceau de lecture (22') présentent une seconde source lumineuse (32) pour générer un faisceau de lecture (22') avec une longueur d'onde ou une polarisation différente de celle du faisceau d'écriture (10) et
- des moyens d'injection (34) pour injecter le faisceau de lecture (22') dans la trajectoire du faisceau d'écriture (10) devant les moyens d'entraînement (12,14) et
- **en ce que** les moyens de désaccouplage (20) désaccouplent le faisceau de lecture (22').

13. Dispositif lithographique selon la revendication 11 ou 12, **caractérisé en ce que** la distance focale du second objectif (24) est plus grande d'un facteur prédéterminé que la distance focale du premier objectif (16).

14. Dispositif lithographique selon la revendication 9 ou 10,
**caractérisé en ce que**
- le premier objectif (40) et le second objectif (42) sont fixés sur un bras de support monté apte à tourner (44),
- un premier dispositif d'entraînement (48) est prévu pour générer un mouvement de rotation oscillant du bras de support (44) et
- un second dispositif d'entraînement (56) est prévu pour générer un déplacement linéaire de la matrice de déclenchement (18) et du palier de pivotement (46) du bras de support (44) par rapport au support mémoire (4),
- le faisceau d'écriture (10) éclairant complètement le premier objectif (40) à l'intérieur de sa zone de déplacement.

15. Dispositif lithographique selon la revendication 14, **caractérisé en ce qu'**une fibre (47) est raccordée au second objectif (42) pour acheminer le faisceau de lecture (22).

16. Dispositif lithographique selon la revendication 14, **caractérisé en ce que** le second objectif (42) focalise une partie du faisceau de lecture élargi (22) sur la surface de la matrice de déclenchement (18).

17. Dispositif lithographique selon l'une quelconque des revendications 14 à 16, **caractérisé en ce que** le premier objectif (40) est disposé à une première distance de l'axe de rotation (46) du bras de support (44) et le second objectif (42) est disposé à une seconde distance de l'axe de rotation (46), la seconde distance étant supérieure à la première distance.

18. Dispositif lithographique selon la revendication 17, **caractérisé en ce que** le premier objectif (40) et le second objectif (42) sont aménagés sur le bras de support (44) sur les côtés opposés de l'axe de rotation (46).

19. Dispositif lithographique selon l'une quelconque des revendications 14 à 18, **caractérisé en ce que** les seconds moyens d'entraînement (56) présentent une démultiplication mécanique qui provoque un rapport de déplacement entre le déplacement de la matrice de déclenchement (18) et celui du palier de rotation (46) du bras de support (44) par rapport au support mémoire (4).

20. Dispositif lithographique selon l'une quelconque des revendications 9 à 19, **caractérisé en ce que** la matrice de déclenchement (18) présente une pluralité de pixels.

21. Dispositif lithographique selon la revendication 20, **caractérisé en ce que** les pixels sont disposés dans une trame, en particulier une trame orthogonale.

22. Dispositif lithographique selon la revendication 20 ou 21, **caractérisé en ce que** la matrice de déclenchement (18) se présente sous la forme d'un convertisseur optoélectronique, en particulier sous la forme d'une puce CCD ou d'une puce CMOS.

23. Dispositif lithographique selon l'une quelconque des revendications 9 à 22, **caractérisé en ce que** les moyens de commande (26) présentent, pour générer un signal de déclenchement, des supports mémoires qui sont raccordés aux pixels de la matrice de déclenchement (18).

24. Dispositif lithographique selon l'une quelconque des revendications 9 à 23, **caractérisé en ce qu'**il est prévu des moyens pour ajuster la distance entre le support mémoire (4) et l'objectif (16) ou la lentille d'écriture (40).

25. Microscope pour lire un objet (4), comprenant :
- une source lumineuse (8) pour générer un faisceau d'observation (10),
- des moyens d'entraînement (12,14; 48,56) pour déplacer dans deux dimensions le faisceau d'observation (10) par rapport à l'objet (4) et
- un premier objectif (16) pour focaliser le faisceau d'observation (10) sur l'objet (4),
**caractérisé en ce que**
- il est prévu une matrice de déclenchement bidimensionnelle (18),
- il est prévu des moyens (32,34,20) pour générer un faisceau de lecture (22,22'),
- il est prévu un second objectif (24) pour focaliser le faisceau de lecture (22,22') sur la matrice de déclenchement (18),
- les moyens d'entraînement (12,14; 48,56) déplacent le faisceau de lecture (22,22') dans deux dimensions par rapport à la surface de la matrice de déclenchement (18), le déplacement du faisceau de lecture (22,22') étant couplé au déplacement du faisceau d'observation (10).

26. Microscope selon la revendication 25 avec les caractéristiques d'une ou plusieurs des revendications 9 à 24.
